# EUROPEAN PATENT APPLICATION

(11) **EP 4 738 995 A1**
(43) Date of publication of application: **06.05.2026**
(21) Application number: 23943311.3
(22) Date of filing: 20.11.2023
(51) Int. Cl.: H05B 6/68, H05K 1/02, H05K 1/18

(54) **CIRCUIT BOARD, TRANSFORMER, MICROWAVE GENERATION DEVICE, AND HOUSEHOLD APPLIANCE**

(30) Priority: 30.06.2023 CN 202310802439; 30.06.2023 CN 202321710711 U
(71) Applicant: Guangdong Midea Kitchen Appliances Manufacturing Co., Ltd., Foshan, Guangdong 528311 (CN)
(72) Inventor: CHENG, Yan, Foshan, Guangdong 528311 (CN); LI, Qinghai, Foshan, Guangdong 528311 (CN); XU, Xiaoping, Foshan, Guangdong 528311 (CN); CHEN, Fei, Foshan, Guangdong 528311 (CN); GAO, Wei, Foshan, Guangdong 528311 (CN); LIU, Xinghua, Foshan, Guangdong 528311 (CN); WANG, Fubao, Foshan, Guangdong 528311 (CN)
(74) Representative: RGTH
(86) International application number: PCT/CN2023/132687
(87) International publication number: WO 2025/000834

(57) **Abstract**

Provided are a circuit board (100), a transformer (50), a microwave generation device (1000), and a household appliance. The circuit board (100) is applied to the microwave generation device (1000). The circuit board (100) includes a substrate (10) and a power device (20). The power device (20) includes a rectifier bridge stack and an insulated-gate bipolar transistor that are integrated as one piece. The power device (20) is disposed at the substrate (10).

## Description

### CROSS-REFERENCE TO RELATED APPLICATION

This application claims priority to and the benefit of patent applications Nos. 202310802439.5 and 202321710711.9, both filed with China National Intellectual Property Administration on June 30, 2023, the entire contents of which are incorporated herein by reference.

### FIELD

The present disclosure relates to the field of microwave technologies, and more particularly, to a circuit board, a transformer, a microwave generation device, and a household appliance.

### BACKGROUND

In the related art, the microwave oven is provided with a control board which comprises a substrate, a rectifier bridge stack, and an insulated-gate bipolar transistor. Each of the rectifier bridge stack and the insulated-gate bipolar transistor is disposed at the substrate. This arrangement occupies a large amount of space, resulting in an excessively large volume of the control board.

### SUMMARY

An embodiment of the present disclosure provides a circuit board, a transformer, a microwave generation device, and a household appliance.

The circuit board according to the embodiment of the present disclosure is applied to the microwave generation device. The circuit board comprises a substrate and a power device disposed at the substrate. The power device comprises a rectifier bridge stack and an insulated-gate bipolar transistor that are integrated as one piece.

By integrating the rectifier bridge stack and the insulated-gate bipolar transistor into the power device, the circuit board can make a combined structure of the rectifier bridge stack and the insulated-gate bipolar transistor more compact. Therefore, an occupied space on the circuit board can be reduced and thus a volume can be minimized, facilitating miniaturization of the circuit board.

In some embodiments, the power device comprises a package body of a cuboid shape.

In some embodiments, the package body has a fixation hole formed at each of two sides of the package body. The circuit board further comprises a radiator disposed at the substrate. The package body is attached to the radiator via the fixation hole.

In some embodiments, the radiator comprises: a heat-transfer portion disposed at the substrate and being of a plate-like shape, the heat-transfer portion having an attachment surface attached to the package body; side fins extending outwardly from a surface of the heat-transfer portion opposite to the attachment surface; and top fins extending upwardly from an end of the heat-transfer portion away from the substrate.

In some embodiments, the circuit board comprises a resonant capacitor. A receiving space is formed between the top fins and the substrate, the resonant capacitor being received in the receiving space.

In some embodiments, the circuit board comprises a transformer. The transformer comprises: a bobbin assembly mounted at the substrate, the bobbin assembly having a primary winding slot and a secondary winding slot, and being provided with a first baffle, a second baffle, a third baffle, and a support plate, the first baffle covering an opening of an upper portion of the primary winding slot or an opening of an upper portion of the secondary winding slot in a height direction of the transformer, and the second baffle covering the opening of a lower portion of the primary winding slot or the opening of a lower portion of the secondary winding slot in the height direction of the transformer; and a magnetic core assembly mounted at the bobbin assembly, the magnetic core assembly comprising a first magnetic core. The first magnetic core is disposed at a side where the secondary winding slot is formed. The substrate is provided with capacitor assemblies at a side of the substrate where the first magnetic core is located. The support plate abuts against tops of the capacitor assemblies. The support plate spaces the first magnetic core and the capacitor assemblies apart from each other in the height direction of the transformer. pins are disposed between capacitor assemblies. The third baffle is connected to the support plate and extends towards a side where the capacitor assemblies are provided, to cover at least part of the pins.

In some embodiments, the bobbin assembly comprises a first bobbin and a second bobbin. The primary winding slot and the secondary winding slot are formed at the first bobbin. The first baffle, the second baffle, the third baffle, and the support plate are disposed at the second bobbin. The first bobbin has a first receiving groove, a through hole, and a second receiving groove. The first receiving groove, the through hole, and the second receiving groove are in communication with each other. The first magnetic core is located in the first receiving groove and the through hole. The magnetic core assembly further comprises a second magnetic core located in the second receiving groove and the through hole.

In some embodiments, the first magnetic core comprises a first connection portion located in the first receiving groove and a first extension portion located in the through hole. The second magnetic core comprises a second connection portion located in the second receiving groove and a second extension portion located in the through hole.

In some embodiments, the second bobbin has a first limiting groove and a second limiting groove. The first connection portion is located in the first limiting groove to limit the first magnetic core. The second connection portion is located in the second limiting groove to limit the second magnetic core. A gap is formed between the first extension portion and the second extension portion.

In some embodiments, the first bobbin is detachably connected to the second bobbin.

In some embodiments, the first receiving groove is provided with a plurality of fixation portions protruding from an outer side of a top wall of the first receiving groove, the plurality of fixation portions having a plurality of strip-shaped slots.

In some embodiments, a radiator is disposed at a side where the second magnetic core is located. The bobbin assembly further comprises a third bobbin attached to top fins. The power device is disposed between the third bobbin and a heat-transfer portion.

In some embodiments, the circuit board comprises a bus capacitor and a differential mode inductor. The bus capacitor is disposed between the differential mode inductor and the transformer. The differential mode inductor and the bus capacitor are arranged at the substrate in sequence.

An embodiment of the present disclosure provides a transformer. The transformer comprises a circuit board; a bobbin assembly mounted at the circuit board, the bobbin assembly having a primary winding slot and a secondary winding slot, and being provided with a first baffle, a second baffle, a third baffle, and a support plate, the first baffle covering an opening of an upper portion of the primary winding slot or an opening of an upper portion of the secondary winding slot in a height direction of the transformer, and the second baffle covering the opening of a lower portion of the primary winding slot or the opening of a lower portion of the secondary winding slot in the height direction of the transformer; and a magnetic core assembly mounted at the bobbin assembly, the magnetic core assembly comprising a first magnetic core. The first magnetic core is disposed at a side where the secondary winding slot is formed. The circuit board is provided with capacitor assemblies at a side of the circuit board where the first magnetic core is located. The support plate abuts against tops of the capacitor assemblies. The support plate spaces the first magnetic core and the capacitor assemblies apart from each other in the height direction of the transformer. Second pins are disposed between capacitor assemblies. The third baffle is connected to the support plate and extends towards a side where the capacitor assemblies are provided to cover at least part of the second pins.

In the above transformer, the first baffle of the bobbin assembly covers the opening of the upper portion of the primary winding slot or the opening of the upper portion of the secondary winding slot. The second baffle covers the opening of the lower portion of the primary winding slot or the opening of the lower portion of the secondary winding slot. In this way, meeting an insulation safety distance between the primary winding slot and the secondary winding slot can be facilitated. The support plate abuts against the tops of the capacitor assemblies to fix the capacitor assemblies. The third baffle covers the at least part of the pins, which can facilitate meeting an insulation safety distance between the first magnetic core and the pins rather than by means of increasing a height of a bobbin wall or a height of a bobbin. Therefore, a volume of the transformer can be significantly reduced and thus a cost of the transformer can be lowered.

In some embodiments, the bobbin assembly comprises a first bobbin and a second bobbin. The primary winding slot and the secondary winding slot are formed at the first bobbin. The first baffle, the second baffle, the third baffle, and the support plate are disposed at the second bobbin. The first bobbin has a first receiving groove, a through hole, and a second receiving groove. The first receiving groove, the through hole, and the second receiving groove are in communication with each other. The first magnetic core is located in the first receiving groove and the through hole. The magnetic core assembly further comprises a second magnetic core located in the second receiving groove and the through hole.

In some embodiments, the first magnetic core comprises a first connection portion located in the first receiving groove and a first extension portion located in the through hole. The second magnetic core comprises a second connection portion located in the second receiving groove and a second extension portion located in the through hole.

In some embodiments, the second bobbin has a first limiting groove and a second limiting groove. The first connection portion is located in the first limiting groove to limit the first magnetic core. The second connection portion is located in the second limiting groove to limit the second magnetic core. A gap is formed between the first extension portion and the second extension portion.

In some embodiments, the first bobbin is detachably connected to the second bobbin.

In some embodiments, the first receiving groove is provided with a plurality of fixation portions protruding from an outer side of a top wall of the first receiving groove, the plurality of fixation portions having a plurality of strip-shaped slots.

In some embodiments, a radiator is disposed at the circuit board and at a side where the second magnetic core is located. The bobbin assembly further comprises a third bobbin, the third bobbin spacing the second magnetic core and the radiator apart from each other.

In some embodiments, the first bobbin is detachably connected to the third bobbin.

In some embodiments, the second pins serve as output terminals of a secondary winding coil of the transformer; or the second pins are connected to the output terminals of the secondary winding coil of the transformer.

An embodiment of the present disclosure provides a microwave generation device. The microwave generation device comprises the circuit board according to any one of the above embodiments; or the transformer according to any one of the above embodiments.

When the above microwave generation device comprises the circuit board, by integrating the rectifier bridge stack and the insulated-gate bipolar transistor into a single power device, the combined structure of the rectifier bridge stack and the insulated-gate bipolar transistor becomes more compact. In this way, the occupied space on the circuit board and thus minimizing the volume of the circuit board is reduced, facilitating miniaturization of the circuit board.

When the above microwave generation device comprises the transformer, the first baffle of the bobbin assembly covers the opening of the upper portion of the primary winding slot or the opening of the upper portion of the secondary winding slot, and the second baffle of the bobbin assembly covers the opening of the lower portion of the primary winding slot or the opening of the lower portion of the secondary winding slot, which can facilitate meeting the insulation safety distance between the primary winding slot and the secondary winding slot. The support plate abuts against the tops of the capacitor assemblies to fix the capacitor assemblies. The third baffle covers the at least part of the second pins, which can facilitate meeting the insulation safety distance between the first magnetic core and the second pins rather than by means of increasing the height of the bobbin wall or the height of the bobbin. In this way, the volume of the transformer can be significantly reduced, and thus the cost of the transformer can be lowered.

An embodiment of the present disclosure provides a household appliance. The household appliance comprises the circuit board according to any one of the above embodiments; or the transformer according to any one of the above embodiments.

When the above household appliance comprises the circuit board, by integrating the rectifier bridge stack and the insulated-gate bipolar transistor into the single power device, the combined structure of the rectifier bridge stack and the insulated-gate bipolar transistor becomes more compact. In this way, the occupied space on the circuit board and thus minimizing the volume of the circuit board is reduced, facilitating miniaturization of the circuit board.

When the above household appliance comprises the transformer, the first baffle of the bobbin assembly covers the opening of the upper portion of the primary winding slot or the opening of the upper portion of the secondary winding slot, and the second baffle of the bobbin assembly covers the opening of the lower portion of the primary winding slot or the opening of the lower portion of the secondary winding slot, which can facilitate meeting the insulation safety distance between the primary winding slot and the secondary winding slot. The support plate abuts against the tops of the capacitor assemblies to fix the capacitor assemblies. The third baffle covers the at least part of the pins, which can facilitate meeting the insulation safety distance between the first magnetic core and the pins rather than by means of increasing the height of the bobbin wall or the height of the bobbin. In this way, the volume of the transformer can be significantly reduced, and thus the cost of the transformer can be lowered.

Additional aspects and advantages of the present disclosure will be provided at least in part in the following description, or will become apparent at least in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings.
FIG. 1 is a partial schematic structural view of a circuit board according to an embodiment of the present disclosure.
FIG. 2 is a schematic structural view of a power device according to an embodiment of the present disclosure.
FIG. 3 is a first schematic structural view of a circuit board according to an embodiment of the present disclosure.
FIG. 4 is a second schematic structural view of a circuit board according to an embodiment of the present disclosure.
FIG. 5 is a third schematic structural view of a circuit board according to an embodiment of the present disclosure.
FIG. 6 is a module schematic diagram of a microwave generation device according to an embodiment of the present disclosure.
FIG. 7 is a connection schematic diagram of a partial circuit of a power device according to an embodiment of the present disclosure.
FIG. 8 is a schematic structural view of a transformer according to an embodiment of the present disclosure.
FIG. 9 is a side view of a transformer according to an embodiment of the present disclosure.
FIG. 10 is a schematic structural view of a bobbin assembly and a magnetic core assembly according to an embodiment of the present disclosure.
FIG. 11 is a schematic structural view of a first bobbin according to an embodiment of the present disclosure.
FIG. 12 is a schematic structural view of a first bobbin according to an embodiment of the present disclosure.
FIG. 13 is a schematic structural view of a second bobbin according to an embodiment of the present disclosure.
FIG. 14 is a schematic structural view of a second bobbin and a magnetic core assembly according to an embodiment of the present disclosure.
FIG. 15 is a schematic structural view of a third bobbin according to an embodiment of the present disclosure.
FIG. 16 is a schematic view of positions of a first baffle and a second baffle according to an embodiment of the present disclosure.
FIG. 17 is another schematic view of positions of a first baffle and a second baffle according to an embodiment of the present disclosure.
FIG. 18 is yet another schematic view of positions of a first baffle and a second baffle according to an embodiment of the present disclosure.
FIG. 19 is still yet another schematic view of positions of a first baffle and a second baffle according to an embodiment of the present disclosure.

### Description of reference numerals of main components:

100 circuit board; 10 substrate; 20 power device; 21 rectifier diode; 22 package body; 24 fixation hole; 26 first pin; 27 high-voltage pin; 28 low-voltage pin; 30 screw; 40 radiator; 42 heat-transfer portion; 44 attachment surface; 46 top fin; 48 side fin; 50 transformer; 60 bus capacitor; 70 differential mode inductor; 80 resonant capacitor; 82 receiving space;
112 bobbin assembly; 114 second pin; 116 primary winding slot; 118 secondary winding slot; 120 first baffle; 122 second baffle; 124 third baffle; 126 support plate; 128 magnetic core assembly; 130 first magnetic core; 132 capacitor assembly; 134 first bobbin; 136 second bobbin; 138 first receiving groove; 140 through hole; 142 second receiving groove; 144 second magnetic core; 146 first connection portion; 148 first extension portion; 150 second connection portion; 152 second extension portion; 154 first limiting groove; 156 second limiting groove; 158 fixation portion; 160 strip-shaped slot; 164 third bobbin; 166 air gap;
1000 microwave generation device.

### DETAILED DESCRIPTION OF THE EMBODIMENTS

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative, and are only intended to explain, rather than limiting, the present disclosure.

In the description of the present disclosure, the terms such as "first" and "second" are only used for descriptive purposes, and cannot be understood as indicating or implying relative importance or implicitly indicating the number of indicated technical features. Therefore, the features associated with "first" and "second" may explicitly or implicitly comprise at least one or more of the features. In the description of the present disclosure, "plurality" means two or more, unless otherwise specifically defined.

In the description of the present disclosure, it should be noted that, unless otherwise clearly stipulated and limited, terms such as "mount", "connect", and "connect to" should be understood in a broad sense. For example, it may be a fixed connection or a detachable connection or connection as one piece; mechanical connection or electrical connection; direct connection or indirect connection through an intermediate; or internal communication of two components or an interaction relationship between two components. For those skilled in the art, specific meanings of the above-mentioned terms in the present disclosure can be understood according to specific circumstances.

Various embodiments or examples for implementing different structures of the embodiments of the present disclosure are provided below. In order to simplify the description of the embodiments of the present disclosure, components and arrangements of specific examples are described herein. Of course, these specific examples are merely for the purpose of illustration, rather than limiting the present disclosure. Further, the same reference numerals and/or reference letters may appear in different examples of the present disclosure for the purpose of simplicity and clarity, instead of indicating a relationship between different embodiments and/or the discussed arrangements. In addition, the present disclosure provides examples of various specific processes and materials. However, applications of other processes and/or the use of other materials are conceivable for those of ordinary skill in the art.

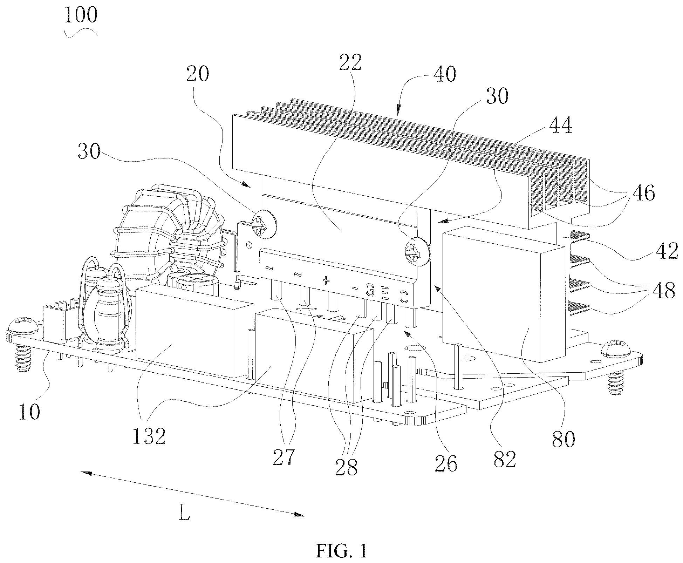

As illustrated in FIG. 1, a circuit board 100 according to an embodiment of the present disclosure is applied to a microwave generation device 1000. The circuit board 100 comprises a substrate 10 and a power device 20. The power device 20 comprises a rectifier bridge stack (not illustrated) and an insulated-gate bipolar transistor (not illustrated) that are integrated as one piece. The power device 20 is disposed at the substrate 10.

By integrating the rectifier bridge stack and the insulated-gate bipolar transistor into the power device 20, the circuit board 100 can make a combined structure of the rectifier bridge stack and the insulated-gate bipolar transistor more compact. Therefore, an occupied space on the circuit board 100 can be reduced and thus a volume of the circuit board 100 can be minimized, facilitating miniaturization of the circuit board 100.

In an exemplary embodiment of the present disclosure, a power semiconductor device is required in a driving power supply circuit of the microwave generation device 1000. The rectifier bridge stack and the insulated-gate bipolar transistor belong to the power semiconductor device. The rectifier bridge stack may be configured to convert an alternating current into a direct current. The insulated-gate bipolar transistor may be configured to control the resonant circuit. In the embodiment shown in FIG. 1, the rectifier bridge stack and the insulated-gate bipolar transistor may be integrated into a single power device 20. The substrate 10 may be rectangular. The substrate 10 may support the power device 20. The power device 20 is disposed at the substrate 10 and close to an edge of the circuit board 100, which can make the combined structure of the rectifier bridge stack and the insulated-gate bipolar transistor more compact. In this way, an occupied space on the circuit board 100 and thus minimizing the volume of the circuit board 100 is reduced, facilitating miniaturization of the circuit board 100.

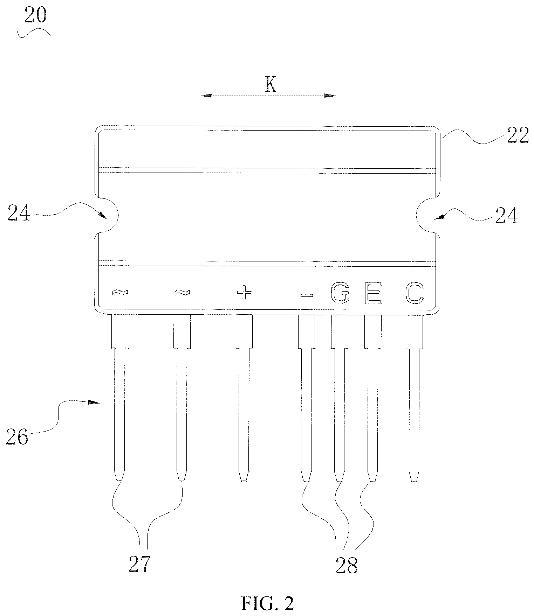

As illustrated in FIG. 2, in some embodiments, the power device 20 comprises a package body 22 of a cuboid shape.

In this way, the package body 22 of the cuboid shape can be better compatible with a shape of an existing rectifier bridge stack and a shape of an existing insulated-gate bipolar transistor, which can more effectively minimize a volume of the power device 20 while facilitating integration.

In an exemplary embodiment of the present disclosure, the power device 20 comprises the package body 22. The package body 22 may be the cuboid shape. In FIG. 1, a length direction of the circuit board 100 may be denoted by L. The package body 22 may be disposed above the substrate 10 in an L direction of the circuit board 100. By designing the package body 22 into a cuboid shape, the package body 22 can be better compatible with the shape of the existing rectifier bridge stack and the shape of the existing insulated-gate bipolar transistor, which can more effectively minimize the volume of the power device 20 while facilitating integration. In addition, in other embodiments, the package body 22 may also be set into an oblong shape or other shapes for better compatibility. The present disclosure is not limited in this regard.

As illustrated in FIG. 1 and FIG. 2, in some embodiments, the package body 22 has a fixation hole 24 formed at each of two sides of the package body 22. The circuit board 100 further comprises a radiator 40 disposed at the substrate 10. The package body 22 is attached to the radiator 40 via the fixation hole 24.

In this way, the package body 22 can be better attached to the radiator 40, improving a heat dissipation effect.

In an exemplary embodiment of the present disclosure, in the embodiment shown in FIG. 2, the length direction of the package body 22 may be denoted by K. The package body 22 has two fixation holes 24. The two fixation holes 24 may be respectively disposed at positions of two sides of the package body 22 close to a middle part in a K direction of the package body 22. The fixation holes 24 may be arc-shaped. Side walls of the fixation holes 24 may be connected to a side surface of the package body 22. In FIG. 1, the radiator 40 may be disposed at the edge of the substrate 10 close to the substrate 10. The circuit board 100 is provided with a screw 30. The fixation holes 24 may pass through two sides of the package body 22 via the screw 30, attaching and fixing the package body 22 to the radiator 40 at an end close to the radiator 40.

It should be noted that the arc-shaped fixation hole 24 may facilitate disassembly of the package body 22, improving an operation efficiency. In one embodiment, when the package body 22 needs to be disassembled, a screw 30 at a side of the package body 22 may be completely unscrewed, and then a screw 30 at another side of the package body 22 may be loosened without being completely unscrewed. Then the package body 22 may be disassembled, which can improve a disassembly speed. In addition, in other embodiments, not only two fixation holes 24 may be provided, but also three fixation holes 24 or other numbers of fixation holes 24 may be provided. A shape of the fixation hole 24 may be in an arc shape, or in other shapes. The present disclosure is not limited in this regard.

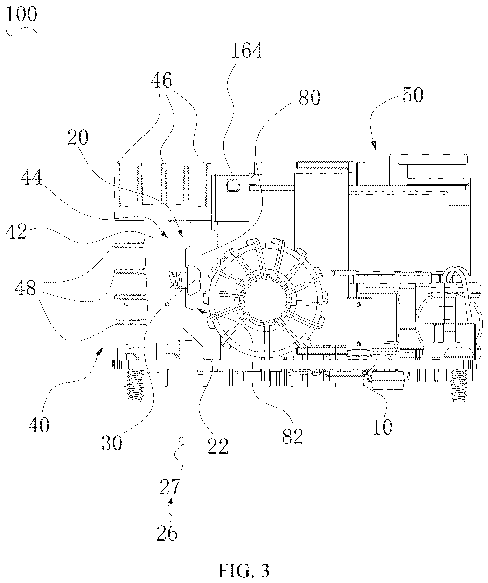

As illustrated in FIG. 1 and FIG. 3, in some embodiments, the radiator 40 comprises a heat-transfer portion 42 disposed at the substrate 10 and being of a plate-like shape. The heat-transfer portion 42 has an attachment surface 44 attached to the package body 22. The radiator 40 comprises: side fins 48 extending outwardly from a surface of the heat-transfer portion 42 opposite to the attachment surface 44; and top fins 46 extending upwardly from an end of the heat-transfer portion 42 away from the substrate 10.

In this way, the fins can be arranged using a space, increasing a heat dissipation area while reserving a space to receive the power device 20, which can effectively control a volume of the radiator 40. Also, a structure of the radiator 40 and the power device 20 can be more compact, controlling the volume of the circuit board 100 as a whole.

In an exemplary embodiment of the present disclosure, in the embodiment shown in FIG. 3, the radiator 40 is provided with the heat-transfer portion 42. The heat-transfer portion 42 may be of the plate-like shape and disposed at the substrate 10. The heat-transfer portion 42 has the attachment surface 44 located at a side of the heat-transfer portion 42. The package body 22 may be attached and fixed to the heat-transfer portion 42 via the attachment surface 44. The radiator 40 is also provided with side fins 48 and top fins 46. The side fins 48 may be disposed at the surface of the heat-transfer portion 42 opposite to the attachment surface 44 and may extend outwardly. The top fins 46 may be disposed at the end of the heat-transfer portion 42 away from the substrate 10 and may extend upwardly. In FIG. 3, five top fins 46 and four side fins 48 are provided. By arranging the top fins 46 and the side fins 48 respectively on the end of the heat-transfer portion 42 away from the substrate 10 and the surface opposite to the attachment surface 44, the heat dissipation area can be increased while the space can be reserved to receive the power device 20. In this way, the volume of the radiator 40 can be effectively controlled, and the structure of the radiator 40 and the power device 20 can be more compact, controlling the volume of the circuit board 100 as a whole.

In addition, other numbers of top fins 46 and side fins 48 can also be provided, which can be adjusted as desired. The present disclosure is not limited in this regard.

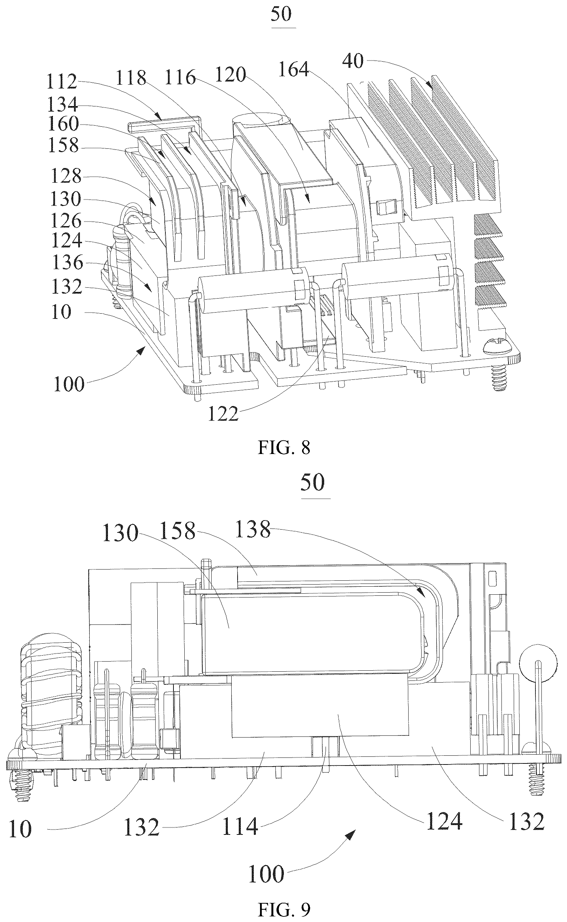

As illustrated in FIG. 8 to FIG. 19, the circuit board 100 comprises a transformer 50. The transformer 50 comprises a substrate 10, a bobbin assembly 112, and a magnetic core assembly 128. The bobbin assembly 112 is mounted at the substrate 10. The bobbin assembly 112 has a primary winding slot 116 and a secondary winding slot 118. The bobbin assembly 112 is provided with a first baffle 120, a second baffle 122, a third baffle 124, and a support plate 126. In a height direction of the transformer 50, the first baffle 120 covers an opening of an upper portion of the primary winding slot 116 or an opening of an upper portion of the secondary winding slot 118, and the second baffle 122 covers the opening of a lower portion of the primary winding slot 116 or the opening of a lower portion of the secondary winding slot 118.

The magnetic core assembly 128 is mounted at the bobbin assembly 112. The magnetic core assembly 128 comprises a first magnetic core 130. The first magnetic core 130 is disposed at a side of the bobbin assembly 112 where the secondary winding slot 118 is formed. The substrate 10 is provided with capacitor assemblies 132 at a side of the substrate 10 where the first magnetic core 130 is located. The support plate 126 abuts against tops of the capacitor assemblies 132. The support plate 126 spaces the first magnetic core 130 and the capacitor assemblies 132 apart from each other in the height direction of the transformer 50. Second pins 114 are disposed between capacitor assemblies 132. The third baffle 124 is connected to the support plate 126 and extends towards the capacitor assemblies 132 to cover at least part of the pins 114.

In this way, a first baffle 120 of the bobbin assembly 112 covers the opening of the upper portion of the primary winding slot 116 or the opening of the upper portion of the secondary winding slot 118, and the second baffle 122 covers the opening of the lower portion of the primary winding slot 116 or the opening of the lower portion of the secondary winding slot 118, which can facilitate meeting an insulation safety distance between the primary winding slot 116 and the secondary winding slot 118. The support plate 126 abuts against the top of the capacitor assembly 132 to fix the capacitor assembly 132. The third baffle 124 covers the at least part of the second pins 114, which can facilitate meeting an insulation safety distance between the first magnetic core 130 and the second pins 114 rather than by means of increasing a height of a bobbin wall or a height of a bobbin. Therefore, a volume of the transformer 50 can be significantly reduced and thus a cost of the transformer 50 can be lowered.

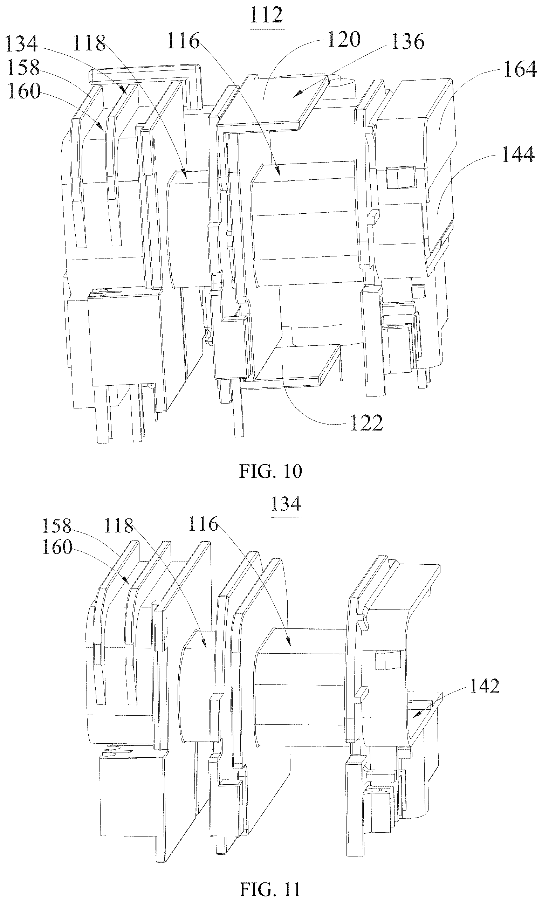

In an exemplary embodiment of the present disclosure, as illustrated in FIG. 8 and FIG. 10, the bobbin assembly 112 of the transformer 50 is mounted at the substrate 10. The magnetic core assembly 128 is fixed at the bobbin assembly 112. The bobbin assembly 112 has the primary winding slot 116 and the secondary winding slot 118 formed at a surface of the bobbin assembly 112. The primary winding slot 116 and the secondary winding slot 118 are grooves for winding a coil, which are one of key components of the transformer 50. Main functions thereof comprise fixing the coil, protecting the coil, improving magnetic flux, and reducing magnetic leakage. During operation, there is a high voltage at a side of the primary winding slot 116 and a side of the secondary winding slot 118. Therefore, the primary winding slot 116 and the secondary winding slot 118 need to meet the corresponding insulation safety distance. In the related art, the insulation safety distance is met by prolonging a height of a side wall of the primary winding slot 116 and a height of a side wall of the secondary winding slot 118, that is, by increasing the height of the bobbin wall or the height of the bobbin. As a result, the volume of the transformer 50 may often be too large.

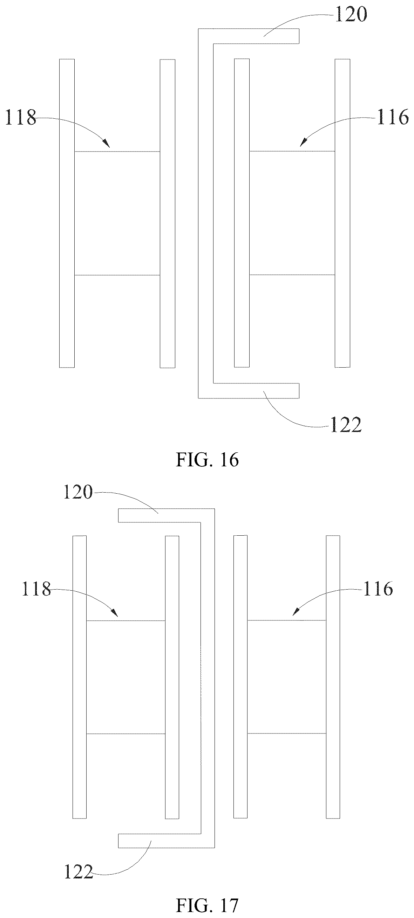

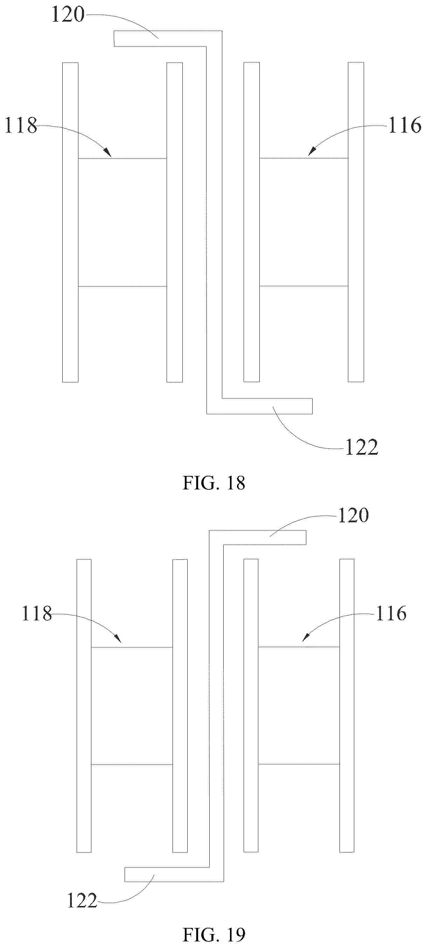

As illustrated in FIG. 10 and FIG. 16 to FIG. 19. FIG. 16 to FIG. 19 are simplified schematic diagrams of multiple positions of the first baffle and the second baffle according to an embodiment of the present disclosure. In the height direction of the transformer 50, the first baffle 120 of the bobbin assembly 112 covers the opening of the upper portion of the primary winding slot 116 or the opening of the upper portion of the secondary winding slot 118, and a second baffle 122 of the bobbin assembly 112 covers the opening of the lower portion of the primary winding slot 116 or the opening of the lower portion of the secondary winding slot 118. In this way, the insulation safety distance between a side where the primary winding slot 116 is located and a side where the secondary winding slot 118 is located can be met, the volume of the transformer 50 can be significantly reduced, and the cost of the transformer 50 can be lowered. In this embodiment, as illustrated in FIG. 10 and FIG. 16, in the height direction of the transformer 50, the first baffle 120 of the bobbin assembly 112 covers the opening of the upper portion of the primary winding slot 116, and the second baffle 122 of the bobbin assembly 112 covers the opening of the lower portion of the primary winding slot 116. As illustrated in FIG. 10 and FIG. 17, in the height direction of the transformer 50, the first baffle 120 of the bobbin assembly 112 covers the opening of the upper portion of the secondary winding slot 118, and the second baffle 122 of the bobbin assembly 112 covers the opening of the lower portion of the secondary winding slot 118. As illustrated in FIG. 10 and FIG. 18, in the height direction of the transformer 50, the first baffle 120 of the bobbin assembly 112 covers the opening of the upper portion of the secondary winding slot 118, and the second baffle 122 of the bobbin assembly 112 covers the opening of the lower portion of the primary winding slot 116. As illustrated in FIG. 10 and FIG. 19, in the height direction of the transformer 50, the first baffle 120 of the bobbin assembly 112 covers the opening of the upper portion of the primary winding slot 116, and the second baffle 122 of the bobbin assembly 112 covers the opening of the lower portion of the secondary winding slot 118.

As illustrated in FIG. 8 and FIG. 9, the magnetic core assembly 128 is mounted at the bobbin assembly 112. The first magnetic core 130 of the magnetic core assembly 128 is disposed at a side of the bobbin assembly 112 where the secondary winding slot 118 is formed. The substrate 10 is provided with capacitor assemblies 132 at the side of the substrate 10 where the first magnetic core 130 is located. The first magnetic core 130 and the capacitor assemblies 132 are arranged at intervals in the height direction of the transformer 50. In some embodiments, the capacitor assemblies 132 may comprise two voltage doubling rectifier capacitors spaced apart from each other on the substrate 10. The support plate 126 of the bobbin assembly 112 abuts against the tops of the capacitor assemblies 132. The support plate 126 spaces the first magnetic core 130 and the capacitor assemblies 132 apart from each other in the height direction of the transformer 50. Second pins 114 are disposed between the capacitor assemblies 132. In some embodiments, the second pins 114 may serve as output terminals of a secondary winding coil of the transformer 50, or the second pins 114 are connected to the output terminals of the secondary winding coil of the transformer 50. A third baffle 124 of the bobbin assembly 112 is connected to the support plate 126 and extends towards the capacitor assemblies 132 to cover the at least part of the second pins 114. In this way, the support plate 126 abuts against the tops of the capacitor assemblies 132 to fix the capacitor assemblies 132 on the substrate 10, which can prevent the capacitor assemblies 132, i.e., the voltage doubling rectifier capacitors, from floating during wave soldering of the substrate 10 and causing cold solder joints. In addition, the third baffle 124 is connected to the support plate 126 and extends towards the capacitor assemblies 132 to cover the at least part of the second pins 114, increasing an insulation safety distance between the second pins 114 and the first magnetic core 130.

In some embodiments, as illustrated in FIG. 8 and FIG. 10 to FIG. 13, the bobbin assembly 112 comprises a first bobbin 134 and a second bobbin 136. The primary winding slot 116 and the secondary winding slot 118 are formed at the first bobbin 134. The first baffle 120, the second baffle 122, the third baffle 124, and the support plate 126 are disposed at the second bobbin 136. The first bobbin 134 has a first receiving groove 138, a through hole 140, and a second receiving groove 142. The first receiving groove 138, the through hole 140, and the second receiving groove 142 are in communication with each other. The first magnetic core 130 is located in the first receiving groove 138 and the through hole 140. The magnetic core assembly 128 further comprises a second magnetic core 144 located in the second receiving groove 142 and the through hole 140.

Accordingly, the first bobbin 134 can fix the magnetic core assembly 128. Arrangement of the first baffle 120, the second baffle 122, and the third baffle 124 at the second bobbin 136 can meet the insulation safety distance.

In an exemplary embodiment of the present disclosure, as illustrated in FIG. 8, FIG. 11, and FIG. 13, the bobbin assembly 112 comprises the first bobbin 134 and the second bobbin 136. The primary winding slot 116 and the secondary winding slot 118 are formed at the first bobbin 134. As illustrated in FIG. 8 and FIG. 10 to FIG. 12, the first receiving groove 138, the through hole 140, and the second receiving groove 142 at the first bobbin 134 are in communication with each other. The first magnetic core 130 of the magnetic core assembly 128 is located in the first receiving groove 138 and the through hole 140. The second magnetic core 144 of the magnetic core assembly 128 is located in the second receiving groove 142 and the through hole 140. In this way, the first bobbin 134 can fix the magnetic core assembly 128. In addition, as mentioned above, the first baffle 120 and the second baffle 122 of the second bobbin 136 can meet the insulation safety distance between the side where the primary winding slot 116 is located and the side where the secondary winding slot 118 is located. A third baffle 124 of the second bobbin 136 can increase the insulation safety distance between the second pins 114 and the first magnetic core 130. In some embodiments, to meet adaptability requirements of the volume of the transformer 50, one or two of the first baffle 120, the second baffle 122, and the third baffle 124 may be provided in the transformer 50. That is, only one or two of the first baffle 120, the second baffle 122, and the third baffle 124 may be present in the transformer 50.

In some embodiments, as illustrated in FIG. 8, FIG. 11, and FIG. 12, the first magnetic core 130 comprises a first connection portion 146 located in the first receiving groove 138 and a first extension portion 148 located in the through hole 140. The second magnetic core 144 comprises a second connection portion 150 located in the second receiving groove 142 and a second extension portion 152 located in the through hole 140.

In this way, the first receiving groove 138, the through hole 140, and the second receiving groove 142 at the first bobbin 134 can fix the magnetic core assembly 128.

In an exemplary embodiment of the present disclosure, as illustrated in FIG. 8, FIG. 11, and FIG. 12, the first bobbin 134 has the first receiving groove 138, the through hole 140, and the second receiving groove 142 that are in communication with each other. The first connection portion 146 of the first magnetic core 130 is located in the first receiving groove 138 of the first bobbin 134. The first extension portion 148 is located in the through hole 140. The second connection portion 150 of the second magnetic core 144 is located in the second receiving groove 142. The second extension portion 152 is located in the through hole 140. The first bobbin 134 is configured to fix the magnetic core assembly 128. The magnetic core assembly 128 can improve an efficiency and power density of the transformer 50 and reduce an electrical energy loss. Therefore, the magnetic core assembly 128 is an important component of the transformer 50.

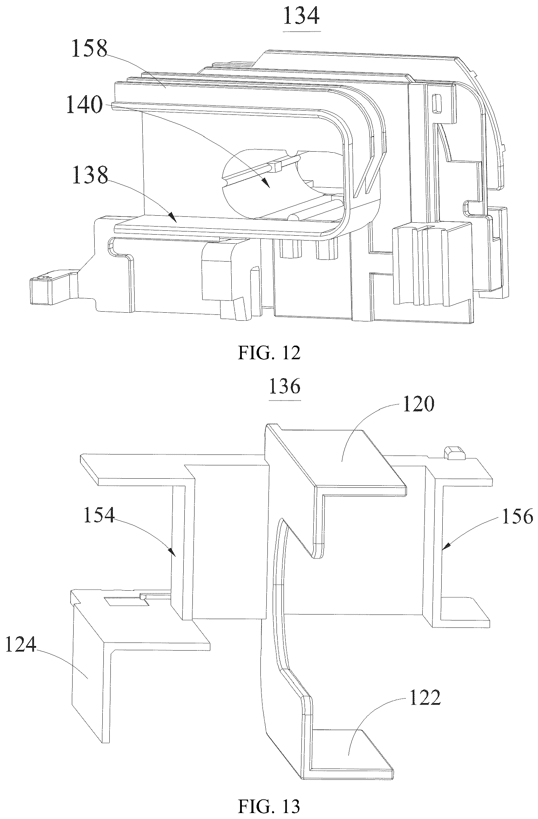

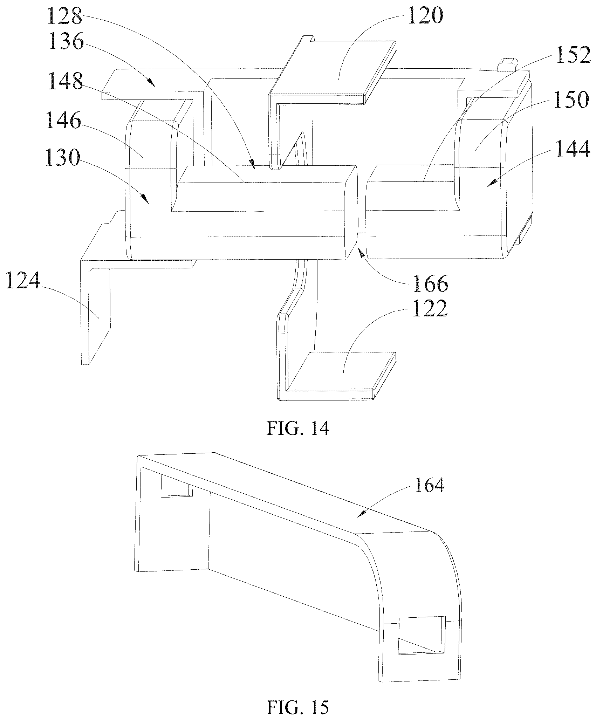

In some embodiments, as illustrated in FIG. 13 and FIG. 14, the second bobbin 136 has a first limiting groove 154 and a second limiting groove 156. The first connection portion 146 is located in the first limiting groove 154 to limit the first magnetic core 130. The second connection portion 150 is located in the second limiting groove 156 to limit the second magnetic core 144. A gap is formed between the first extension portion 148 and the second extension portion 152.

In this way, the gap between the first extension portion 148 and the second extension portion 152 can form an air gap 166.

In an exemplary embodiment of the present disclosure, as illustrated in FIG. 13 and FIG. 14, the second bobbin 136 comprises the first limiting groove 154 and the second limiting groove 156. The first connection portion 146 is located in the first limiting groove 154 to limit the first magnetic core 130. The second connection portion 150 is located in the second limiting groove 156 to limit the second magnetic core 144. The gap between the first extension portion 148 and the second extension portion 152 refers to the air gap 166 formed between the first magnetic core 130 and the second magnetic core 144. The air gap 166 between the first magnetic core 130 and the second magnetic core 144 can improve the efficiency of the transformer 50 and reduce an energy loss. An appropriately designed air gap 166 can help control a magnetic flux path and magnetic field distribution, enabling the transformer 50 to operate more stably and reliably. In this embodiment, a suitable air gap 166 can be achieved by properly configuring the second bobbin 136.

In some embodiments, as illustrated in FIG. 8, FIG. 11, and FIG. 13, the first bobbin 134 is detachably connected to the second bobbin 136.

In this way, detachable connection between the first bobbin 134 and the second bobbin 136 can facilitate winding of the primary winding slot 116 and the secondary winding slot 118 of the first bobbin 134.

In an exemplary embodiment of the present disclosure, as illustrated in FIG. 8, FIG. 11, and FIG. 13, the first bobbin 134 is detachably connected to the second bobbin 136. In some embodiments, during assembly of the transformer 50, the primary winding slot 116 and the secondary winding slot 118 of the first bobbin 134 are wound, and then the second bobbin 136 is mounted onto the first bobbin 134. After the first bobbin 134 and the second bobbin 136 are assembled, the magnetic core assembly 128 is mounted onto the bobbin assembly 112.

In some embodiments, as illustrated in FIG. 8, FIG. 10, and FIG. 11, the first receiving groove 138 is provided with a plurality of fixation portions 158 protruding from an outer side of a top wall of the first receiving groove 138. The plurality of fixation portions 158 have a plurality of strip-shaped slots 160.

In this way, the plurality of fixation portions 158 protruding from the outer side of the top wall of the first receiving groove 138 can increase an insulation safety distance between the secondary winding slot 118 and the first magnetic core 130. The strip-shaped slots 160 formed by the fixation portions 158 can facilitate wiring.

In an exemplary embodiment of the present disclosure, as illustrated in FIG. 8, FIG. 10, and FIG. 11, the first magnetic core 130 is disposed in the first receiving groove 138. The secondary winding slot 118 is spaced apart from the first magnetic core 130 by the top wall and a side wall of the first receiving groove 138. The plurality of fixation portions 158 protruding from the outer side of the top wall of the first receiving groove 138 can increase the insulation safety distance between the secondary winding slot 118 and the first magnetic core 130. In addition, the plurality of fixation portions 158 define the strip-shaped slots 160, which may be used for wiring. In some embodiments, the strip-shaped slots 160 may be configured to fix magnetron filament leads.

In some embodiments, as illustrated in FIG. 8, FIG. 10, and FIG. 15, a radiator 40 is disposed at the substrate 10. The radiator 40 is disposed at a side of the bobbin assembly 112 where the second magnetic core 144 is located. The bobbin assembly 112 further comprises a third bobbin 164. The third bobbin 164 spaces the second magnetic core 144 and the radiator 40 apart from each other.

In this way, the radiator 40 can dissipate heat from the transformer 50. The third bobbin 164 can increase an insulation safety distance between the second magnetic core 144 and the radiator 40.

In an exemplary embodiment of the present disclosure, as illustrated in FIG. 8, the radiator 40 is disposed at the substrate 10. The radiator 40 is disposed at the side of the bobbin assembly 112 where the second magnetic core 144 is located. The radiator 40 is configured to dissipate heat from the transformer 50, controlling and stabilizing a temperature of the transformer 50. Also, the transformer 50 can be prevented from experiencing an excessive temperature rise inside due to excessive heat generated by a current passing through the transformer 50, which may affect performance and a service life of the transformer 50. Moreover, the bobbin assembly 112 further comprises the third bobbin 164. The third bobbin 164 spaces the second magnetic core 144 and the radiator 40 apart from each other. In an exemplary embodiment of the present disclosure, as illustrated in FIG. 10 and FIG. 15, the third bobbin 164 is connected to the second receiving groove 142 at an outer side of a top wall of the second receiving groove 142 and extends towards the substrate 10, spacing the second magnetic core 144 and the radiator 40 apart from each other. Therefore, on one hand, the insulation safety distance between the second magnetic core 144 and the radiator 40 can be increased. On the other hand, the insulation safety distance between the primary winding slot 116 and the second magnetic core 144 can also be increased.

In some embodiments, as illustrated in FIG. 10 and FIG. 15, the first bobbin 134 is detachably connected to the third bobbin 164.

In this way, assembly of the bobbin assembly 112 and the magnetic core assembly 128 can be facilitated.

In an exemplary embodiment of the present disclosure, as illustrated in FIG. 10 and FIG. 15, the first bobbin 134 is detachably connected to the third bobbin 164. As described above, after the first bobbin 134 and the second bobbin 136 are assembled and the magnetic core assembly 128 is mounted, the third bobbin 164 is then mounted at a side of the second magnetic core 144.

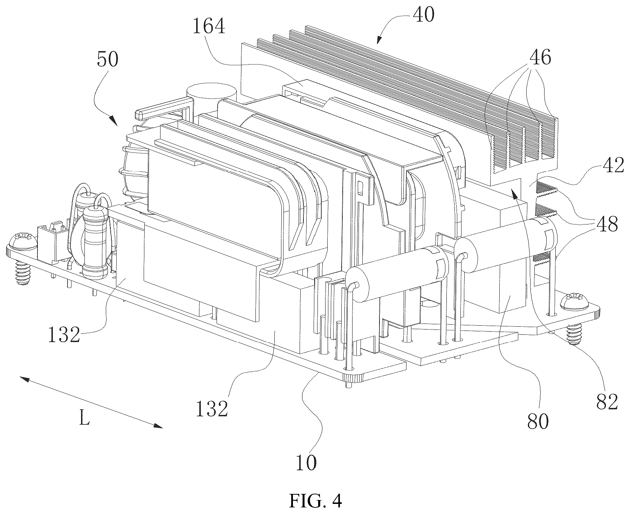

As illustrated in FIG. 3 and FIG. 4, in some embodiments, the radiator 40 is disposed at a side of the bobbin assembly 112 where the second magnetic core 144 is located. The bobbin assembly 112 further comprises the third bobbin 164 attached to the top fins 46. The power device 20 is disposed between the third bobbin 164 and a heat transfer portion 42 of the radiator 40.

In this way, through the attachment arrangement, a heat dissipation efficiency can be enhanced. While ensuring efficient heat dissipation for the transformer 50, the transformer 50, the power device 20, and the radiator 40 can be arranged more compactly, better controlling the volume of the circuit board 100.

In an exemplary embodiment of the present disclosure, in FIG. 3, the transformer 50, as a major component on the circuit board 100, may be disposed close to a center of the substrate 10. The transformer 50 is provided with the third bobbin 164. The third bobbin 164 may be disposed at the substrate 10. The third bobbin 164 may be attached to the top fins 46 at an end of the third bobbin 164 away from the substrate 10 and a side of the third bobbin 164 close to the radiator 40. The power device 20 may be fixedly connected to the attachment surface 44 and disposed below the top fins 46. The power device 20 may be located between the third bobbin 164 and the heat transfer portion 42. In other words, the attachment arrangement between the third bobbin 164 and the top fins 46 can improve the heat dissipation efficiency. While ensuring efficient heat dissipation for the transformer 50, the transformer 50, the power device 20, and the radiator 40 can be arranged more compactly, better controlling the volume of the circuit board 100.

As illustrated in FIG. 2 and FIG. 3, in some embodiments, the power device 20 comprises a plurality of first pins 26. The plurality of first pins 26 extend downwardly from the package body 22. The power device 20 is fixed at the substrate 10 via the plurality of first pins 26. The plurality of first pins 26 comprise a plurality of high-voltage pins 27 and a plurality of low-voltage pins 28. The plurality of high-voltage pins 27 is adjacently arranged, and the plurality of low-voltage pins 28 is adjacently arranged.

In this way, by disposing the plurality of first pins 26, a structural design of the circuit board 100 can be simplified, helping reducing the volume of the circuit board 100.

In an exemplary embodiment of the present disclosure, in FIG. 2, the power device 20 is provided with seven first pins 26. The seven first pins 26 are disposed at a bottom of the package body 22 and extend downwardly. The power device 20 is fixed at the substrate 10 via the seven first pins 26. The seven first pins 26 comprise two high-voltage pins 27 and three low-voltage pins 28. The two high-voltage pins 27 are adjacently arranged and disposed close to an end of the package body 22. The three low-voltage pins 28 are adjacently arranged and disposed close to an another end of the package body 22. This arrangement of the plurality of first pins 26 can simplify a layout design of the circuit board 100 to some extent, resulting in a simpler structural design and facilitating reduction of the volume of the circuit board 100.

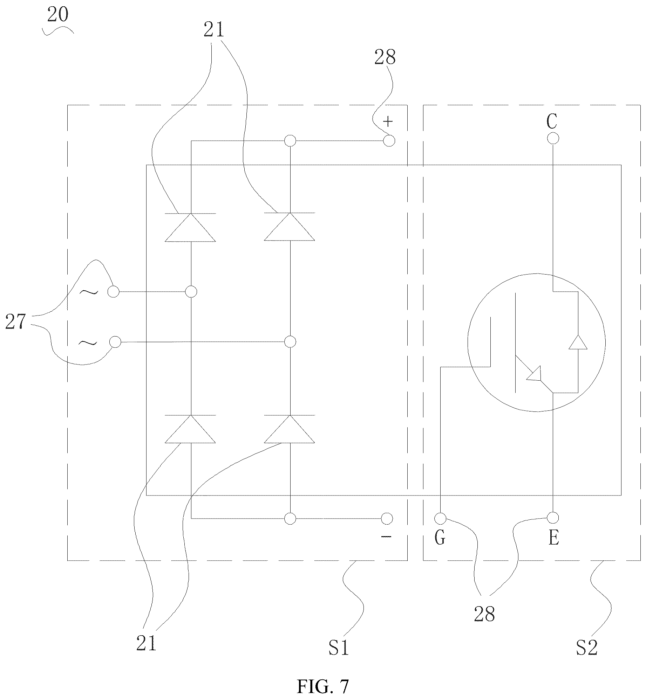

In addition, in the embodiment shown in FIG. 7, the power device 20 comprises the rectifier bridge stack and the insulated-gate bipolar transistor. The circuit of the rectifier bridge stack may comprise four rectifier diodes 21. In one embodiment, by applying the alternating current to the high-voltage pins 27 which is converted by the rectifier diodes 21, the rectifier bridge stack can transform the alternating current into the direct current , and the direct current can be output from the low-voltage pins 28. The rectifier bridge stack may be denoted as S1. The insulated-gate bipolar transistor may be denoted as S2.

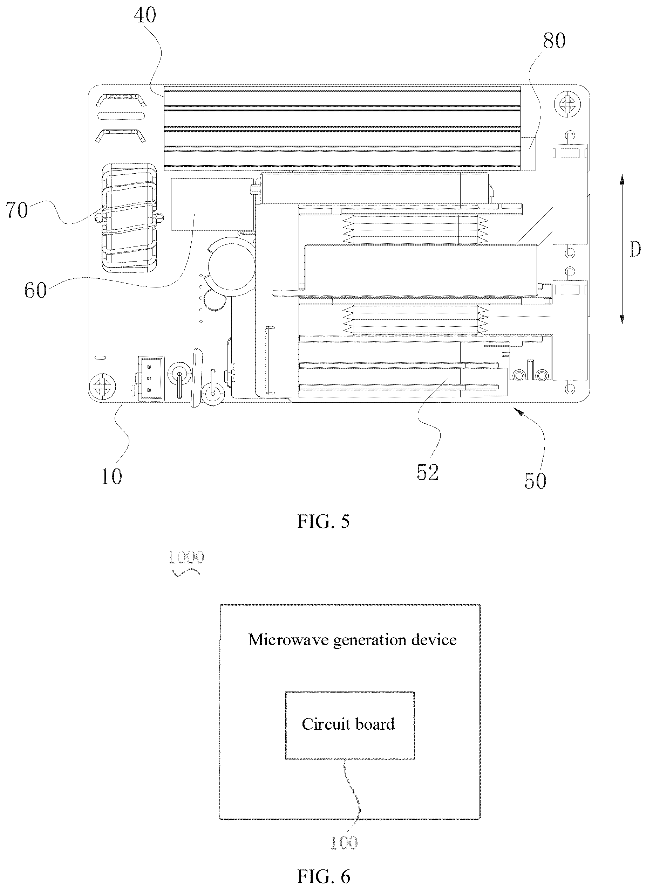

As illustrated in FIG. 5, in some embodiments, the circuit board 100 comprises a bus capacitor 60 and a differential mode inductor 70. The bus capacitor 60 is disposed between the differential mode inductor 70 and the transformer 50. The differential mode inductor 70 and the bus capacitor 60 are arranged at the substrate 10 in sequence.

In this way, a width of the circuit board 100 can be reduced, decreasing the volume of the circuit board 100.

In an exemplary embodiment of the present disclosure, in the embodiment shown in FIG. 5, a width direction of the circuit board 100 may be denoted by D. The differential mode inductor 70 may be disposed close to a side of the circuit board 100. The bus capacitor 60 may be disposed between the differential mode inductor 70 and the third bobbin 164. The differential mode inductor 70 and the bus capacitor 60 may be arranged in sequence in a direction where the substrate 10 is perpendicular to a D direction, reducing the width of the circuit board 100 and thus decreasing the volume of the circuit board 100.

As illustrated in FIG. 1 and FIG. 3, in some embodiments, the circuit board 100 comprises a resonant capacitor 80. A receiving space 82 is formed between the top fins 46 and the substrate 10. The resonant capacitor 80 is received in the receiving space 82.

In this way, the resonant capacitor 80 can be received in the receiving space 82, realizing compact arrangement between the resonant capacitor 80 and the radiator 40 and reducing the volume of the circuit board 100.

In an exemplary embodiment of the present disclosure, in the embodiment shown in FIG. 1, the radiator 40 may be disposed away from a center of the circuit board 100. The radiator 40 may have a T-shaped structure. The top fin 46 and the substrate 10 cooperate to define a receiving space 82. The resonant capacitor 80 may be inserted into the substrate 10 and located in the receiving space 82. The resonant capacitor 80 is arranged close to the heat-transfer portion 42. Since the resonant capacitor 80 is disposed in the receiving space 82, heat can be dissipated from a top surface and a side surface of the resonant capacitor 80, improving the heat dissipation efficiency and further reducing the volume of the circuit board 100.

In addition, in the related art, a high voltage is present between a primary side and a secondary side of the transformer. To meet an insulation safety distance between a primary coil and a secondary coil of the transformer, a height of a bobbin wall at the primary winding coil needs to be typically increased. In addition, to increase an insulation safety distance between a secondary coil pin and a magnetic core of the transformer, the height of the bobbin or a height of the magnetic core needs to be increased. In this way, the transformer tends to have an excessively large volume and a high manufacturing cost.

As illustrated in FIG. 8 to FIG. 19, the transformer 50 according to an embodiment of the present disclosure comprises the substrate 10, the bobbin assembly 112, and the magnetic core assembly 128. The bobbin assembly 112 is mounted at the substrate 10. The bobbin assembly 112 has a primary winding slot 116 and a secondary winding slot 118. The bobbin assembly 112 is provided with a first baffle 120, a second baffle 122, a third baffle 124, and a support plate 126. In a height direction of the transformer 50, the first baffle 120 covers an opening of an upper portion of the primary winding slot 116 or an opening of an upper portion of the secondary winding slot 118, and the second baffle 122 covers the opening of a lower portion of the primary winding slot 116 or the opening of a lower portion of the secondary winding slot 118.

The magnetic core assembly 128 is mounted at the bobbin assembly 112. The magnetic core assembly 128 comprises a first magnetic core 130. The first magnetic core 130 is disposed at a side of the bobbin assembly 112 where the secondary winding slot 118 is formed. The substrate 10 is provided with capacitor assemblies 132 at a side of the substrate 10 where the first magnetic core 130 is located. The support plate 126 abuts against tops of the capacitor assemblies 132. The support plate 126 spaces the first magnetic core 130 and the capacitor assemblies 132 apart from each other in the height direction of the transformer 50. Second pins 114 are disposed between capacitor assemblies 132. The third baffle 124 is connected to the support plate 126 and extends towards the capacitor assemblies 132 to cover at least part of the pins 114.

In this way, the first baffle 120 of the bobbin assembly 112 covers the opening of the upper portion of the primary winding slot 116 or the opening of the upper portion of the secondary winding slot 118, and the second baffle 122 of the bobbin assembly 112 covers the opening of the lower portion of the primary winding slot 116 or the opening of the lower portion of the secondary winding slot 118, which can facilitate meeting the insulation safety distance between the primary winding slot 116 and the secondary winding slot 118. The support plate 126 abuts against the tops of the capacitor assemblies 132 to fix the capacitor assemblies 132. The third baffle 124 covers the at least part of the second pins 114, which can facilitate meeting the insulation safety distance between the first magnetic core 130 and the second pins 114 rather than by means of increasing the height of the bobbin wall or the height of the bobbin. Therefore, the volume of the transformer 50 can be significantly reduced, and thus the cost of the transformer 50 can be lowered.

In an exemplary embodiment of the present disclosure, as illustrated in FIG. 8 and FIG. 10, the bobbin assembly 112 of the transformer 50 is mounted at the substrate 10. The magnetic core assembly 128 is fixed at the bobbin assembly 112. The bobbin assembly 112 has the primary winding slot 116 and the secondary winding slot 118 formed at the surface of the bobbin assembly 112. The primary winding slot 116 and the secondary winding slot 118 are grooves for winding the coil, which are one of the key components of the transformer 50. Main functions thereof comprise fixing the coil, protecting the coil, improving magnetic flux, and reducing magnetic leakage. During operation, there is the high voltage at the side of the primary winding slot 116 and the side of the secondary winding slot 118. Therefore, the primary winding slot 116 and the secondary winding slot 118 need to meet the corresponding insulation safety distance. In the related art, the insulation safety distance may be met by prolonging the height of the side wall of the primary winding slot 116 and the height of the side wall of the secondary winding slot 118, that is, by increasing the height of the bobbin wall or the height of the bobbin. As a result, the volume of the transformer 50 may often be too large.

As illustrated in FIG. 10 and FIG. 16 to FIG. 19. FIG. 16 to FIG. 19 are simplified schematic diagrams of multiple positions of the first baffle and the second baffle according to an embodiment of the present disclosure. In the height direction of the transformer 50, the first baffle 120 of the bobbin assembly 112 covers the opening of the upper portion of the primary winding slot 116 or the opening of the upper portion of the secondary winding slot 118, and a second baffle 122 of the bobbin assembly 112 covers the opening of the lower portion of the primary winding slot 116 or the opening of the lower portion of the secondary winding slot 118. In this way, the insulation safety distance between the side where the primary winding slot 116 is located and the side where the secondary winding slot 118 is located can be met, the volume of the transformer 50 can be significantly reduced, and the cost of the transformer 50 can be lowered. In this embodiment, as illustrated in FIG. 10 and FIG. 16, in the height direction of the transformer 50, the first baffle 120 of the bobbin assembly 112 covers the opening of the upper portion of the primary winding slot 116, and the second baffle 122 of the bobbin assembly 112 covers the opening of the lower portion of the primary winding slot 116. As illustrated in FIG. 10 and FIG. 17, in the height direction of the transformer 50, the first baffle 120 of the bobbin assembly 112 covers the opening of the upper portion of the secondary winding slot 118, and the second baffle 122 of the bobbin assembly 112 covers the opening of the lower portion of the secondary winding slot 118. As illustrated in FIG. 10 and FIG. 18, in the height direction of the transformer 50, the first baffle 120 of the bobbin assembly 112 covers the opening of the upper portion of the secondary winding slot 118, and the second baffle 122 of the bobbin assembly 112 covers the opening of the lower portion of the primary winding slot 116. As illustrated in FIG. 10 and FIG. 19, in the height direction of the transformer 50, the first baffle 120 of the bobbin assembly 112 covers the opening of the upper portion of the primary winding slot 116, and the second baffle 122 of the bobbin assembly 112 covers the opening of the lower portion of the secondary winding slot 118.

As illustrated in FIG. 8 and FIG. 9, the magnetic core assembly 128 is mounted at the bobbin assembly 112. The first magnetic core 130 of the magnetic core assembly 128 is disposed at the side of the bobbin assembly 112 where the secondary winding slot 118 is formed. The substrate 10 is provided with capacitor assemblies 132 at the side of the substrate 10 where the first magnetic core 130 is located. The first magnetic core 130 and the capacitor assemblies 132 are arranged at intervals in the height direction of the transformer 50. In some embodiments, the capacitor assemblies 132 may comprise two voltage doubling rectifier capacitors spaced apart from each other on the substrate 10. The support plate 126 of the bobbin assembly 112 abuts against the tops of the capacitor assemblies 132. The support plate 126 spaces the first magnetic core 130 and the capacitor assemblies 132 apart from each other in the height direction of the transformer 50. Second pins 114 are disposed between the capacitor assemblies 132. In some embodiments, the second pins 114 may serve as output terminals of the secondary winding coil of the transformer 50, or the second pins 114 are connected to the output terminals of the secondary winding coil of the transformer 50. The third baffle 124 of the bobbin assembly 112 is connected to the support plate 126 and extends towards the capacitor assemblies 132 to cover the at least part of the second pins 114. In this way, the support plate 126 abuts against the tops of the capacitor assemblies 132 to fix the capacitor assemblies 132 on the substrate 10, which can prevent the capacitor assemblies 132, i.e., the voltage doubling rectifier capacitors, from floating during wave soldering of the substrate 10 and causing cold solder joints. In addition, the third baffle 124 is connected to the support plate 126 and extends towards the capacitor assemblies 132 to cover the at least part of the second pins 114, increasing the insulation safety distance between the second pins 114 and the first magnetic core 130.

In some embodiments, as illustrated in FIG. 8 and FIG. 10 to FIG. 13, the bobbin assembly 112 comprises a first bobbin 134 and a second bobbin 136. The primary winding slot 116 and the secondary winding slot 118 are formed at the first bobbin 134. The first baffle 120, the second baffle 122, the third baffle 124, and the support plate 126 are disposed at the second bobbin 136. The first bobbin 134 has a first receiving groove 138, a through hole 140, and a second receiving groove 142. The first receiving groove 138, the through hole 140, and the second receiving groove 142 are in communication with each other. The first magnetic core 130 is located in the first receiving groove 138 and the through hole 140. The magnetic core assembly 128 further comprises a second magnetic core 144 located in the second receiving groove 142 and the through hole 140.

In this way, the first bobbin 134 can fix the magnetic core assembly 128. Arrangement of the first baffle 120, the second baffle 122, and the third baffle 124 at the second bobbin 136 can meet the insulation safety distance.

In an exemplary embodiment of the present disclosure, as illustrated in FIG. 8, FIG. 11, and FIG. 13, the bobbin assembly 112 comprises the first bobbin 134 and the second bobbin 136. The primary winding slot 116 and the secondary winding slot 118 are formed at the first bobbin 134. As illustrated in FIG. 8 and FIG. 10 to FIG. 12, the first receiving groove 138, the through hole 140, and the second receiving groove 142 at the first bobbin 134 are in communication with each other. The first magnetic core 130 of the magnetic core assembly 128 is located in the first receiving groove 138 and the through hole 140. The second magnetic core 144 of the magnetic core assembly 128 is located in the second receiving groove 142 and the through hole 140. In this way, the first bobbin 134 can fix the magnetic core assembly 128. In addition, as mentioned above, the first baffle 120 and the second baffle 122 of the second bobbin 136 can meet the insulation safety distance between the side where the primary winding slot 116 is located and the side where the secondary winding slot 118 is located. The third baffle 124 of the second bobbin 136 can increase the insulation safety distance between the second pins 114 and the first magnetic core 130. In some embodiments, to meet adaptability requirements of the volume of the transformer 50, one or two of the first baffle 120, the second baffle 122, and the third baffle 124 may be provided in the transformer 50. That is, only one or two of the first baffle 120, the second baffle 122, and the third baffle 124 may be present in the transformer 50.

In some embodiments, as illustrated in FIG. 8, FIG. 11, and FIG. 12, the first magnetic core 130 comprises a first connection portion 146 located in the first receiving groove 138 and a first extension portion 148 located in the through hole 140. The second magnetic core 144 comprises a second connection portion 150 located in the second receiving groove 142 and a second extension portion 152 located in the through hole 140.

In this way, the first receiving groove 138, the through hole 140, and the second receiving groove 142 at the first bobbin 134 can fix the magnetic core assembly 128.

In an exemplary embodiment of the present disclosure, as illustrated in FIG. 8, FIG. 11, and FIG. 12, the first bobbin 134 has the first receiving groove 138, the through hole 140, and the second receiving groove 142 that are in communication with each other. The first connection portion 146 of the first magnetic core 130 is located in the first receiving groove 138 of the first bobbin 134. The first extension portion 148 is located in the through hole 140. The second connection portion 150 of the second magnetic core 144 is located in the second receiving groove 142. The second extension portion 152 is located in the through hole 140. The first bobbin 134 is configured to fix the magnetic core assembly 128. The magnetic core assembly 128 can improve the efficiency and the power density of the transformer 50 and reduce the electrical energy loss. Therefore, the magnetic core assembly 128 is the important component of the transformer 50.

In some embodiments, as illustrated in FIG. 13 and FIG. 14, the first limiting groove 154 and the second limiting groove 156 are formed at the second bobbin 136. The first connection portion 146 is located in the first limiting groove 154 to limit the first magnetic core 130. The second connection portion 150 is located in the second limiting groove 156 to limit the second magnetic core 144. A gap is formed between the first extension portion 148 and the second extension portion 152.

In this way, the gap between the first extension portion 148 and the second extension portion 152 can form the air gap 166.

In an exemplary embodiment of the present disclosure, as illustrated in FIG. 13 and FIG. 14, the second bobbin 136 comprises the first limiting groove 154 and the second limiting groove 156. The first connection portion 146 is located in the first limiting groove 154 to limit the first magnetic core 130. The second connection portion 150 is located in the second limiting groove 156 to limit the second magnetic core 144. The gap between the first extension portion 148 and the second extension portion 152 refers to the air gap 166 formed between the first magnetic core 130 and the second magnetic core 144. The air gap 166 between the first magnetic core 130 and the second magnetic core 144 can improve the efficiency of the transformer 50 and reduce the energy loss. The appropriately designed air gap 166 can help control the magnetic flux path and the magnetic field distribution, enabling the transformer 50 to operate more stably and reliably. In this embodiment, the suitable air gap 166 can be achieved by properly configuring the second bobbin 136.

In some embodiments, as illustrated in FIG. 8, FIG. 11, and FIG. 13, the first bobbin 134 is detachably connected to the second bobbin 136.

In this way, detachable connection between the first bobbin 134 and the second bobbin 136 can facilitate winding of the primary winding slot 116 and the secondary winding slot 118 of the first bobbin 134.

In an exemplary embodiment of the present disclosure, as illustrated in FIG. 8, FIG. 11, and FIG. 13, the first bobbin 134 is detachably connected to the second bobbin 136. In some embodiments, during assembly of the transformer 50, the primary winding slot 116 and the secondary winding slot 118 of the first bobbin 134 are wound, and then the second bobbin 136 is mounted onto the first bobbin 134. After the first bobbin 134 and the second bobbin 136 are assembled, the magnetic core assembly 128 is mounted onto the bobbin assembly 112.

In some embodiments, as illustrated in FIG. 8, FIG. 10, and FIG. 11, the first receiving groove 138 is provided with a plurality of fixation portions 158 protruding from an outer side of a top wall of the first receiving groove 138. The plurality of fixation portions 158 have a plurality of strip-shaped slots 160.

In this way, the plurality of fixation portions 158 protruding from the outer side of the top wall of the first receiving groove 138 can increase the insulation safety distance between the secondary winding slot 118 and the first magnetic core 130. The strip-shaped slots 160 formed by the fixation portions 158 can facilitate wiring.

In an exemplary embodiment of the present disclosure, as illustrated in FIG. 8, FIG. 10, and FIG. 11, the first magnetic core 130 is disposed in the first receiving groove 138. The secondary winding slot 118 is spaced apart from the first magnetic core 130 by the top wall and a side wall of the first receiving groove 138. The plurality of fixation portions 158 protruding from the outer side of the top wall of the first receiving groove 138 can increase the insulation safety distance between the secondary winding slot 118 and the first magnetic core 130. In addition, the plurality of fixation portions 158 define the strip-shaped slots 160, which may be used for wiring. In some embodiments, the strip-shaped slots 160 may be configured to fix magnetron filament leads.

In some embodiments, as illustrated in FIG. 8, FIG. 10, and FIG. 15, a radiator 40 is disposed at the substrate 10. The radiator 40 is disposed at a side of the bobbin assembly 112 where the second magnetic core 144 is located. The bobbin assembly 112 further comprises a third bobbin 164. The third bobbin 164 spaces the second magnetic core 144 and the radiator 40 apart from each other.

In this way, the radiator 40 can dissipate heat from the transformer 50. The third bobbin 164 can increase the insulation safety distance between the second magnetic core 144 and the radiator 40.

In an exemplary embodiment of the present disclosure, as illustrated in FIG. 8, the radiator 40 is disposed at the substrate 10. The radiator 40 is disposed at the side of the bobbin assembly 112 where the second magnetic core 144 is located. The radiator 40 is configured to dissipate heat from the transformer 50, controlling and stabilizing the temperature of the transformer 50. Also, the transformer 50 can be prevented from experiencing the excessive temperature rise inside due to the excessive heat generated by the current passing through the transformer 50, which may affect the performance and service life of the transformer 50. Moreover, the bobbin assembly 112 further comprises the third bobbin 164. The third bobbin 164 spaces the second magnetic core 144 and the radiator 40 apart from each other. In an exemplary embodiment of the present disclosure, as illustrated in FIG. 10 and FIG. 15, the third bobbin 164 is connected to the second receiving groove 142 at the outer side of the top wall of the second receiving groove 142 and extends towards the substrate 10, spacing the second magnetic core 144 and the radiator 40 apart from each other. Therefore, on one hand, the insulation safety distance between the second magnetic core 144 and the radiator 40 can be increased. On the other hand, the insulation safety distance between the primary winding slot 116 and the second magnetic core 144 can also be increased.

In some embodiments, as illustrated in FIG. 10 and FIG. 15, the first bobbin 134 is detachably connected to the third bobbin 164.

In this way, assembly of the bobbin assembly 112 and the magnetic core assembly 128 can be facilitated.

In an exemplary embodiment of the present disclosure, as illustrated in FIG. 10 and FIG. 15, the first bobbin 134 is detachably connected to the third bobbin 164. As described above, after the first bobbin 134 and the second bobbin 136 are assembled and the magnetic core assembly 128 is mounted, the third bobbin 164 is then mounted at the side of the second magnetic core 144.

An embodiment of the present disclosure provides a household appliance. The household appliance comprises the transformer 50 according to any one of the above embodiments; or the circuit board 100 according to any one of the above embodiments.

When the above household appliance comprises the transformer 50, the first baffle 120 of the bobbin assembly 112 covers the opening of the upper portion of the primary winding slot 116 or the opening of the upper portion of the secondary winding slot 118, and the second baffle 122 of the bobbin assembly 112 covers the opening of the lower portion of the primary winding slot 116 or the opening of the lower portion of the secondary winding slot 118, which can facilitate meeting the insulation safety distance between the primary winding slot 116 and the secondary winding slot 118. The support plate 126 abuts against the top of the capacitor assembly 132 to fix the capacitor assembly 132. The third baffle 124 covers the at least part of the pins 114, which can facilitate meeting the insulation safety distance between the first magnetic core 130 and the pins 114 rather than by means of increasing the height of the bobbin wall or the height of the bobbin. In this way, the volume of the transformer 50 can be significantly reduced, and thus the cost of the transformer 50 can be lowered.

In an exemplary embodiment of the present disclosure, in the above household appliance, the household appliance comprises the transformer 50. The transformer 50 comprises the circuit board 100, the bobbin assembly 112, and the magnetic core assembly 128. The bobbin assembly 112 is mounted at the circuit board 100. The bobbin assembly 112 has the primary winding slot 116 and the secondary winding slot 118. The bobbin assembly 112 is provided with the first baffle 120, the second baffle 122, the third baffle 124, and the support plate 126. In the height direction of the transformer 50, the first baffle 120 covers the opening of the upper portion of the primary winding slot 116 or the opening of the upper portion of the secondary winding slot 118, and the second baffle 122 covers the opening of the lower portion of the primary winding slot 116 or the opening of the lower portion of the secondary winding slot 118. The magnetic core assembly 128 is mounted at the bobbin assembly 112. The magnetic core assembly 128 comprises the first magnetic core 130. The first magnetic core 130 is disposed at a side of the bobbin assembly 112 where the secondary winding slot is formed. The circuit board 100 is provided with capacitor assemblies 132 at the side of the circuit board 100 where the first magnetic core 130 is located. The support plate 126 abuts against tops of the capacitor assemblies 132. The support plate 126 spaces the first magnetic core 130 and the capacitor assemblies 132 apart from each other in the height direction of the transformer 50. Second pins 114 are disposed between the capacitor assemblies 132. The third baffle 124 is connected to the support plate 126 and extends towards the capacitor assemblies 132 to cover at least part of the second pins 114.

The first baffle 120 of the bobbin assembly 112 covers the opening of the upper portion of the primary winding slot 116 or the opening of the upper portion of the secondary winding slot 118, and the second baffle 122 of the bobbin assembly 112 covers the opening of the lower portion of the primary winding slot 116 or the opening of the lower portion of the secondary winding slot 118, which can facilitate meeting the insulation safety distance between the primary winding slot 116 and the secondary winding slot 118. The support plate 126 abuts against the tops of the capacitor assemblies 132 to fix the capacitor assemblies 132. The third baffle 124 covers the at least part of the second pins 114, which can facilitate meeting the insulation safety distance between the first magnetic core 130 and the second pins 114 rather than by means of increasing the height of the bobbin wall or the height of the bobbin. Therefore, the volume of the transformer 50 can be significantly reduced and thus the cost of the transformer 50 can be lowered.

When the above household appliance comprises the circuit board 100, by integrating the rectifier bridge stack and the insulated-gate bipolar transistor into the single power device 20, the combined structure of the rectifier bridge stack and the insulated-gate bipolar transistor becomes more compact. In this way, the occupied space on the circuit board 100 and thus minimizing the volume of the circuit board 100 is reduced, facilitating miniaturization of the circuit board 100.

In some embodiments, the household appliance comprises a variable frequency microwave oven.

In an exemplary embodiment of the present disclosure, the variable frequency microwave oven may be used for food heating. The variable frequency microwave oven may adjust an energy output according to characteristics of food and cooking requirements, allowing the food to be heated more evenly, and thus achieving a more efficient cooking effect. In addition, the variable frequency microwave oven may also provide more precise temperature adjustment and heat preservation, which can meet requirements of different types of food and make cooking more convenient and easy to control. The variable frequency microwave oven may comprise a frequency converter. The frequency converter comprises the transformer 50.

As illustrated in FIG. 1 to FIG. 7 and FIG. 8 to FIG. 19, an embodiment of the present disclosure provides a microwave generation device 1000. The microwave generation device 1000 comprises the circuit board 100 according to any one of the above embodiments; or the transformer 50 according to any one of the above embodiments.

When the above microwave generation device 1000 comprises the circuit board 100, by integrating the rectifier bridge stack and the insulated-gate bipolar transistor into the single power device 20, the combined structure of the rectifier bridge stack and the insulated-gate bipolar transistor becomes more compact. In this way, the occupied space on the circuit board 100 and thus minimizing the volume of the circuit board 100 is reduced, facilitating miniaturization of the circuit board 100.

In an exemplary embodiment of the present disclosure, the microwave generation device 1000 comprises the variable frequency microwave oven. A heat dissipation air duct (not illustrated) may be disposed in the microwave generation device 1000. The circuit board 100 may be disposed in the heat dissipation air duct. By reasonably designing a layout of a component on the circuit board 100 based on the heat dissipation air duct, the occupied space on the circuit board 100 can be reduced, miniaturizing the circuit board 100. Therefore, an overall design of the microwave generation device 1000 can be facilitated.

When the above microwave generation device comprises the transformer 50, the first baffle 120 of the bobbin assembly 112 covers the opening of the upper portion of the primary winding slot 116 or the opening of the upper portion of the secondary winding slot 118, and the second baffle 122 of the bobbin assembly 112 covers the opening of the lower portion of the primary winding slot 116 or the opening of the lower portion of the secondary winding slot 118, which can facilitate meeting the insulation safety distance between the primary winding slot 116 and the secondary winding slot 118. The support plate 126 abuts against the tops of the capacitor assemblies 132 to fix the capacitor assemblies. The third baffle 124 covers the at least part of the second pins 114, which can facilitate meeting the insulation safety distance between the first magnetic core 130 and the second pins 114 rather than by means of increasing the height of the bobbin wall or the height of the bobbin. In this way, the volume of the transformer 50 can be significantly reduced and thus the cost of the transformer 50 can be lowered.

Reference throughout this specification to "an embodiment," "some embodiments," "certain embodiments," "illustrative embodiments," "an example," "a specific example," or "some examples" means that a particular feature, structure, material, or characteristic described in connection with the embodiment or example is comprised in at least one embodiment or example of the present disclosure. The appearances of the above phrases in various places throughout this specification are not necessarily referring to the same embodiment or example. In addition, the particular features, structures, materials, or characteristics described may be combined in any suitable manner in any one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. A circuit board for a microwave generation device, wherein the circuit board comprises:
a substrate; and
a power device disposed at the substrate, wherein the power device comprises a rectifier bridge stack and an insulated-gate bipolar transistor that are integrated as one piece.

2. The circuit board according to claim 1, wherein the power device comprises a package body of a cuboid shape.

3. The circuit board according to claim 2, wherein:
the package body has a fixation hole formed at each of two sides of the package body;
the circuit board further comprises a radiator disposed at the substrate; and
the package body is attached to the radiator via the fixation hole.

4. The circuit board according to claim 2 or 3, wherein the power device comprises a plurality of pins extending downwardly from the package body, wherein:
the power device is fixed at the substrate via the plurality of pins; and
the plurality of pins comprise a plurality of high-voltage pins and a plurality of low-voltage pins, the plurality of high-voltage pins being adjacently arranged, and the plurality of low-voltage pins being adjacently arranged.

5. The circuit board according to claim 3 or 4, wherein the radiator comprises:
a heat-transfer portion disposed at the substrate and being of a plate-like shape, the heat-transfer portion having an attachment surface attached to the package body;
a side fin extending outwardly from a surface of the heat-transfer portion opposite to the attachment surface; and
a top fin extending upwardly from an end of the heat-transfer portion away from the substrate.

6. The circuit board according to claim 5, comprising a resonant capacitor, wherein a receiving space is formed between the top fin and the substrate, the resonant capacitor being received in the receiving space.

7. The circuit board according to any one of claims 1 to 6, comprising a transformer, wherein the transformer comprises:
a bobbin assembly mounted at the substrate, the bobbin assembly having a primary winding slot and a secondary winding slot, and being provided with a first baffle, a second baffle, a third baffle, and a support plate, wherein the first baffle covers an opening of an upper portion of the primary winding slot or an opening of an upper portion of the secondary winding slot in a height direction of the transformer, and wherein the second baffle covers the opening of a lower portion of the primary winding slot or the opening of a lower portion of the secondary winding slot in the height direction of the transformer; and
a magnetic core assembly mounted at the bobbin assembly, the magnetic core assembly comprising a first magnetic core, wherein the first magnetic core is disposed at a side where the secondary winding slot is formed, wherein the substrate is provided with capacitor assemblies at a side of the substrate where the first magnetic core is located, wherein the support plate abuts against tops of the capacitor assemblies, wherein the support plate spaces the first magnetic core and the capacitor assemblies apart from each other in the height direction of the transformer, wherein pins are disposed between capacitor assemblies, and wherein the third baffle is connected to the support plate and extends towards a side where the capacitor assemblies are provided, to cover at least part of the pins.

8. The circuit board according to claim 7, wherein the bobbin assembly comprises a first bobbin and a second bobbin, wherein:
the primary winding slot and the secondary winding slot are formed at the first bobbin;
the first baffle, the second baffle, the third baffle, and the support plate are disposed at the second bobbin; and
the first bobbin has a first receiving groove, a through hole, and a second
receiving groove, wherein the first receiving groove, the through hole, and the second receiving groove are in communication with each other, wherein the first magnetic core is located in the first receiving groove and the through hole, and wherein the magnetic core assembly further comprises a second magnetic core located in the second receiving groove and the through hole.

9. The circuit board according to claim 7 or 8, wherein:
the first magnetic core comprises a first connection portion located in the first receiving groove and a first extension portion located in the through hole; and
the second magnetic core comprises a second connection portion located in the second receiving groove and a second extension portion located in the through hole.

10. The circuit board according to claim 8 or 9, wherein:
the second bobbin has a first limiting groove and a second limiting groove, the first connection portion being located in the first limiting groove to limit the first magnetic core, and the second connection portion being located in the second limiting groove to limit the second magnetic core; and
a gap is formed between the first extension portion and the second extension portion.

11. The circuit board according to any one of claims 8 to 10, wherein the first bobbin is detachably connected to the second bobbin.

12. The circuit board according to claim 8 or 9, wherein the first receiving groove is provided with a plurality of fixation portions protruding from an outer side of a top wall of the first receiving groove, the plurality of fixation portions having a plurality of strip-shaped slots.

13. The circuit board according to any one of claims 8 to 10, wherein:
a radiator is disposed at a side where the second magnetic core is located;
the bobbin assembly further comprises a third bobbin attached to a top fin; and
the power device is disposed between the third bobbin and a heat-transfer portion.

14. The circuit board according to any one of claims 7 to 13, comprising:
a bus capacitor; and
a differential mode inductor, wherein the bus capacitor is disposed between the differential mode inductor and the transformer, and wherein the differential mode inductor and the bus capacitor are arranged at the substrate in sequence.

15. A transformer, comprising:
a circuit board;
a bobbin assembly mounted at the circuit board, the bobbin assembly having a primary winding slot and a secondary winding slot, and being provided with a first baffle, a second baffle, a third baffle, and a support plate, wherein the first baffle covers an opening of an upper portion of the primary winding slot or an opening of an upper portion of the secondary winding slot in a height direction of the transformer, and wherein the second baffle covers the opening of a lower portion of the primary winding slot or the opening of a lower portion of the secondary winding slot in the height direction of the transformer; and
a magnetic core assembly mounted at the bobbin assembly, the magnetic core assembly comprising a first magnetic core, wherein the first magnetic core is disposed at a side where the secondary winding slot is formed, wherein the circuit board is provided with capacitor assemblies at a side of the circuit board where the first magnetic core is located, wherein the support plate abuts against tops of the capacitor assemblies, wherein the support plate spaces the first magnetic core and the capacitor assemblies apart from each other in the height direction of the transformer, wherein second pins are disposed between capacitor assemblies, and wherein the third baffle is connected to the support plate and extends towards a side where the capacitor assemblies are provided, to cover at least part of the second pins.

16. The transformer according to claim 15, wherein the bobbin assembly comprises a first bobbin and a second bobbin, wherein:
the primary winding slot and the secondary winding slot are formed at the first bobbin;
the first baffle, the second baffle, the third baffle, and the support plate are disposed at the second bobbin; and
the first bobbin has a first receiving groove, a through hole, and a second receiving groove, wherein the first receiving groove, the through hole, and the second receiving groove are in communication with each other, wherein the first magnetic core is located in the first receiving groove and the through hole, and wherein the magnetic core assembly further comprises a second magnetic core located in the second receiving groove and the through hole.

17. The transformer according to claim 16, wherein:
the first magnetic core comprises a first connection portion located in the first receiving groove and a first extension portion located in the through hole; and
the second magnetic core comprises a second connection portion located in the second receiving groove and a second extension portion located in the through hole.

18. The transformer according to claim 16 or 17, wherein:
the second bobbin has a first limiting groove and a second limiting groove, the first connection portion being located in the first limiting groove to limit the first magnetic core, and the second connection portion being located in the second limiting groove to limit the second magnetic core; and
a gap is formed between the first extension portion and the second extension portion.

19. The transformer according to any one of claims 16 to 18, wherein the first bobbin is detachably connected to the second bobbin.

20. The transformer according to any one of claims 16 to 19, wherein the first receiving groove is provided with a plurality of fixation portions protruding from an outer side of a top wall of the first receiving groove, the plurality of fixation portions having a plurality of strip-shaped slots.

21. The transformer according to any one of claims 16 to 20, wherein:
a radiator is disposed at a side where the second magnetic core is located; and
the bobbin assembly further comprises a third bobbin, the third bobbin spacing the second magnetic core and the radiator apart from each other.

22. The transformer according to claim 21, wherein the first bobbin is detachably connected to the third bobbin.

23. The transformer according to any one of claims 15 to 17, wherein:
the second pins serve as output terminals of a secondary winding coil of the transformer; or
the second pins are connected to output terminals of a secondary winding coil of the transformer.

24. A microwave generation device, comprising:
a circuit board according to any one of claims 1 to 14; or
a transformer according to any one of claims 15 to 23.

25. A household appliance, comprising:
a circuit board according to any one of claims 1 to 14; or
a transformer according to any one of claims 15 to 23.
